# FASCICULE DE BREVET EUROPEEN

(11) **EP 4 137 447 B1**
(45) Date de publication et mention de la délivrance du brevet: **12.06.2024**
(21) Numéro de dépôt: 22188620.3
(22) Date de dépôt: 03.08.2022
(51) Int. Cl.: B81C 3/00, F16B 5/04, F16B 19/06, G04B 13/02, G04D 1/00

(54) **PROCÉDÉ D`ASSEMBLAGE D'UNE PIÈCE EN SILICIUM SUR UN SUPPORT**
VERFAHREN ZUR MONTAGE EINES BAUTEILS AUS SILIZIUM AUF EINER HALTERUNG
METHOD FOR ASSEMBLING A SILICON PART ON A SUPPORT

(30) Priorité: 04.08.2021 FR 2108467
(43) Date de publication de la demande: 22.02.2023
(73) Titulaire: Silmach, 25000 Besançon (FR)
(72) Inventeur: CÔTE, Thierry, 25660 GENNES (FR)
(74) Mandataire: Regimbeau

(56) Documents cités:
- EP-A1- 1 712 342
- EP-A1- 2 273 322
- EP-A1- 3 501 326
- CH-B1- 699 147

## Description

### DOMAINE DE L'INVENTION

La présente invention concerne la fabrication des microsystèmes électromécaniques, aussi dits systèmes MEMS, et en particulier les systèmes MEMS comprenant des composants formés dans des plaquettes ou blocs de matériau semi-conducteur.

L'invention concerne plus particulièrement un procédé d'assemblage d'une pièce en silicium sur un moyeu, ainsi qu'un dispositif MEMS obtenu selon ce procédé d'assemblage.

### ETAT DE LA TECHNIQUE

Il est connu de réaliser des actionneurs ou des capteurs de très haute précision à l'aide de systèmes MEMS, ou microsystèmes électromécaniques. De tels actionneurs ou capteurs MEMS trouvent par exemple des applications dans le domaine de la fabrication horlogère, mais également dans tout autre domaine nécessitant un très haut niveau de maîtrise de la géométrie pour des pièces fabriquées de très petites dimensions.

Du fait de ses propriétés physico-chimiques et de sa disponibilité, le silicium est l'un des matériaux semi-conducteurs privilégiés pour la fabrication de composants de systèmes MEMS. Le silicium est particulièrement approprié pour la fabrication de composants de très faible épaisseur, par exemple de l'ordre de quelques dizaines à quelques centaines de micromètres. La micro-structuration du silicium permet la réalisation de motifs mécaniques de petites dimensions, telles que des micro-indentations de quelques micromètres d'épaisseur. Un matériau plastique ne permettrait pas une micro-structuration avec une maîtrise aussi précise de la géométrie de la pièce réalisée.

Une fois la pièce en silicium réalisée, cette pièce est assemblée sur un substrat ou un support, qui n'est généralement pas lui-même fabriqué en silicium. A titre d'exemple, un élément actionneur en silicium pour un micromoteur MEMS peut être assemblé sur une platine en alliage métallique, en céramique ou en plastique.

Outre une très grande maîtrise de géométrie et de positionnement des composants en silicium garantissant la précision des systèmes MEMS, il est également nécessaire dans de nombreuses applications d'assurer la tenue mécanique des composants en silicium.

Par exemple, dans le cas d'une roue micro-dentée en silicium assemblée sur un moyeu, les spécifications du système MEMS définissent une certaine tenue mécanique nécessaire pour la roue micro-dentée vis-à-vis du couple mécanique de l'élément d'entraînement.

Les composants de systèmes MEMS peuvent être assemblés sur leur support par chassage, c'est-à-dire par pressage d'une portion de la pièce en silicium à l'intérieur d'un logement de dimensions plus petites intégré dans le support. Les composants de systèmes MEMS peuvent également être assemblés sur leur support par rivetage.

Toutefois, la grande fragilité du silicium ne permet généralement pas d'utiliser de telles techniques d'assemblage sans porter préjudice à l'intégrité mécanique de la pièce en silicium. Des micro-ruptures peuvent affecter la pièce en silicium lors de l'assemblage. Compte-tenu de la grande maîtrise souhaitée de la géométrie et du positionnement des pièces en silicium dans les systèmes MEMS, il convient d'éviter des micro-ruptures.

Il a par ailleurs été proposé de coller un actionneur ou un capteur en silicium sur son support après avoir positionné ledit actionneur ou capteur à la position souhaitée, à l'aide par exemple d'une colle à irradiation par ultraviolets ou encore d'une colle thermodurcissable à haute température. Après un ajustement spatial du composant en silicium, on dépose une colle au niveau de zones de collage.

Toutefois, dans certains cas d'application, l'utilisation de colles peut créer des surépaisseurs non souhaitables du composant en silicium au niveau des zones de collage. Une élimination éventuelle de telles surépaisseurs de colle complexifie la fabrication. En outre, il est nécessaire de prévoir un temps d'attente une fois que la pièce en silicium est mise au contact de son support au niveau des zones de collage, afin de laisser agir la colle. Un tel temps d'attente allonge le temps d'assemblage et complexifie la fabrication. Le document EP 2 273 322 A1 D2 divulgue un procédé d'assemblage d'une pièce en silicium sur un moyeu, la pièce en silicium comprenant une ouverture centrale traversante, un bord intérieur délimitant l'ouverture centrale traversante et le moyeu comprenant une portion déformable. Ce procédé comprend des étapes de placer le moyeu à l'intérieur de l'ouverture centrale et de déformer plastiquement la portion déformable par sollicitation mécanique de la portion déformable. L'étape de déformation plastique a pour effet de former un bossage pour remplir un espace dans la pièce en silicium, de manière à bloquer en rotation le moyeu sur la pièce.

### DESCRIPTION GENERALE DE L'INVENTION

Au regard de ce qui précède, il existe un besoin pour un procédé d'assemblage d'une pièce en silicium sur un support, en particulier pour une pièce en silicium de dimensions micrométriques ou millimétriques, garantissant un assemblage sans rupture de la pièce malgré les efforts mécaniques exercés pour l'assemblage.

Un très haut niveau de maîtrise de l'assemblage est souhaité, avec une précision micrométrique du positionnement de la pièce en silicium par rapport au support.

On cherche également à éviter des variations incontrôlées de la géométrie de la pièce, telles que des micro-ruptures ou des surépaisseurs de la pièce, notamment au cours de son assemblage sur le support.

Il existe un besoin additionnel pour un procédé d'assemblage permettant de réduire le temps d'assemblage, tout en maîtrisant la qualité de fabrication.

Pour répondre à ces besoins, selon un premier aspect, l'invention concerne un procédé d'assemblage d'une pièce en silicium sur un moyeu, la pièce en silicium comprenant une ouverture centrale traversante, un bord intérieur délimitant l'ouverture centrale traversante et au moins une encoche s'étendant à partir du bord intérieur, et le moyeu comprenant une portion déformable. Le procédé comprend des étapes de placer le moyeu à l'intérieur de l'ouverture centrale, mettre en contact un outil avec la portion déformable, déformer plastiquement la portion déformable par sollicitation mécanique de la portion déformable à l'aide de l'outil, de sorte qu'une fois déformée, la portion déformable s'étend contre la pièce en formant une butée maintenant la pièce en position sur le moyeu. Ladite étape de déformation plastique a pour effet de déformer le moyeu en formant un bossage pour remplir un espace de l'encoche, de manière à bloquer en rotation le moyeu sur la pièce. On réalise ainsi un assemblage, ou une « hybridation », de la pièce en silicium sur son support.

La sollicitation mécanique est exercée au niveau de la portion déformable, et préférentiellement pas au niveau de la pièce en silicium elle-même. On réduit donc fortement les risques de micro-ruptures ou de déformations mécaniques de la pièce en silicium. L'intégrité mécanique et fonctionnelle de la pièce en silicium est ainsi préservée.

Par ailleurs, on peut omettre tout ajout de matière telle que de la colle au voisinage de la pièce, ce qui évite des surépaisseurs incontrôlées. On maîtrise donc encore davantage la géométrie de la pièce en silicium, ce qui est particulièrement avantageux lorsque la pièce en silicium est destinée à jouer un rôle d'actionneur et/ou de capteur. Un avantage additionnel est qu'il n'est pas nécessaire de prévoir un temps d'attente après la déformation de la portion déformable. Le maintien en position de la pièce en silicium est assuré par la butée à l'issue de l'étape de déformation plastique. Il est donc possible de réduire le temps de fabrication du système assemblé en omettant une étape de collage.

D'autres caractéristiques optionnelles et non-limitatives du procédé d'assemblage tel que défini ci-avant sont les suivantes, prises seules ou en l'une quelconque des combinaisons techniquement possibles :
- le procédé comprend une étape préliminaire de chauffage de l'outil à une température supérieure ou égale à 80 degrés et inférieure ou égale à 200 degrés, de sorte à chauffer la portion déformable au cours de l'étape de déformation.
- l'outil comprend un poinçon.
- l'outil comprend une tête vibrante.
- la tête vibrante est activée pendant l'étape de déformation plastique, de manière à générer des frottements entre l'outil et la portion déformable, les frottements ayant pour effet de chauffer la portion déformable au cours de l'étape de déformation.
- le moyeu comprend un matériau métallique, de préférence l'acier inoxydable et/ou le laiton et/ou le cuprobéryllium.
- le moyeu comprend un matériau thermoplastique, de préférence un polymère à cristaux liquides et/ou un polyacide méthacrylique.
- la portion déformable est formée en une seule pièce unique de matériau avec le reste du moyeu.
- la pièce repose sur une enclume au cours de l'étape de déformation.
- la pièce comprend une surface de contact et repose sur le moyeu via la surface de contact.
- une épaisseur moyenne de la pièce selon une direction perpendiculaire à ladite surface de contact est supérieure ou égale à 10 micromètres et inférieure ou égale à 1,0 millimètre, de préférence supérieure ou égale à 50 micromètres et inférieure ou égale à 500 micromètres.

Selon un deuxième aspect, l'invention se rapporte à un dispositif micro-électromécanique, dit MEMS, comprenant un moyeu et une pièce en silicium assemblée fixement sur le support, le dispositif MEMS ayant été obtenu par un procédé d'assemblage tel que défini ci-avant.

D'autres caractéristiques optionnelles et non-limitatives du dispositif tel que défini ci-avant sont les suivantes, prises seules ou en l'une quelconque des combinaisons techniquement possibles :
- et/ou la pièce en silicium comprend une roue d'entraînement.

### DESCRIPTION GENERALE DES FIGURES

D'autres caractéristiques, buts et avantages de l'invention ressortiront de la description qui suit, qui est purement illustrative et non limitative, et qui doit être lue en regard des dessins annexés parmi lesquels :
La **Figure 1** représente les étapes successives d'un procédé d'assemblage d'une pièce en silicium selon un exemple.
La **Figure 2a** illustre schématiquement une pièce en silicium en cours d'assemblage sur une platine, selon un premier exemple de réalisation dans lequel la portion déformée par l'outil comprend un pion.
La **Figure 2b** est une vue rapprochée de la tête de l'outil positionnée sur le pion, au cours de la déformation du pion dans l'exemple de réalisation de la Figure 2a.
La **Figure 3** est une vue en coupe longitudinale d'un pion selon une première variante.
La **Figure 4** est un schéma de la déformation du pion de la Figure 3 par un outil.
La **Figure 5** est une vue en coupe longitudinale d'un pion selon une deuxième variante.
La **Figure 6** est un schéma de la déformation du pion de la Figure 5 par un outil.
La **Figure 7a** est une vue de dessus d'un actionneur en silicium positionné sur une platine, des éléments de positionnement étant placés face à des surfaces de l'actionneur.
La **Figure 7b** illustre schématiquement le contact entre l'actionneur de la Figure 7a et les éléments de positionnement.
La **Figure 8a** illustre schématiquement une pièce en silicium en cours d'assemblage sur une platine, selon un deuxième exemple de réalisation dans lequel la portion déformée par l'outil est d'une seule pièce avec le reste de la platine.
La **Figure 8b** est une vue schématique de dessus de l'outil et de la pièce en silicium de la Figure 8a au cours de l'assemblage.
La **Figure 9a** illustre schématiquement une roue en silicium en cours d'assemblage sur un moyeu, selon un troisième exemple de réalisation dans lequel la portion déformée par l'outil comprend une partie du moyeu.
La **Figure 9b** est une vue rapprochée de la tête d'outil positionnée sur une partie du moyeu, au cours de la déformation du moyeu dans l'exemple de réalisation de la Figure 9a.
La **Figure 10a** est une vue en coupe longitudinale d'un poinçon de l'outil utilisé pour réaliser la déformation du moyeu dans l'exemple de réalisation de la Figure 9a.
La **Figure 10b** est une vue du dessous de la tête du poinçon de la Figure 10a.
La **Figure 11** illustre schématiquement la roue de silicium et le moyeu au cours de leur assemblage, dans l'exemple de réalisation de la Figure 9a. Les exemples décrites ci-après en référence aux figures 1-8b ne font pas partie de l'invention telle qu'elle est revendiquée. Ces exemples sont présentés uniquement à titre d'illustration. Par contre, l'exemple 2 qui est décrit en référence aux figures 9a - 11 est un mode de réalisation de l'invention.

### DESCRIPTION DETAILLEE DE MODES DE REALISATION DE L'INVENTION

La description ci-après concerne des exemples de procédés d'assemblage d'une pièce en silicium sur un support, comprenant une déformation plastique contrôlée d'une portion déformable du support afin de réaliser une butée au niveau de la portion déformable pour le maintien en position de la pièce. On entend, par « portion déformable » du support, une partie du support prévue pour être déformée de manière contrôlée au cours de l'assemblage. La portion déformable est prévue pour ne pas rompre ou être détruite lors de la déformation. On entend en outre par « déformation plastique » une déformation au moins partiellement irréversible de la portion déformable ; autrement dit, lorsqu'il est mis fin à la sollicitation mécanique de la portion déformable, la portion déformable demeure en position déformée et forme une butée.

On notera que la portion déformable peut être d'une seule pièce avec le reste du support (par exemple dans le cas d'une portion flexible intégrée à une platine du support) ou être dissociée du reste du support (par exemple dans le cas d'un pion à sertir déformable).

Sur l'ensemble des figures annexées et tout au long de la description ci-après, les éléments similaires portent des références alphanumériques identiques.

### Procédé d'assemblage d'une pièce en silicium sur un support

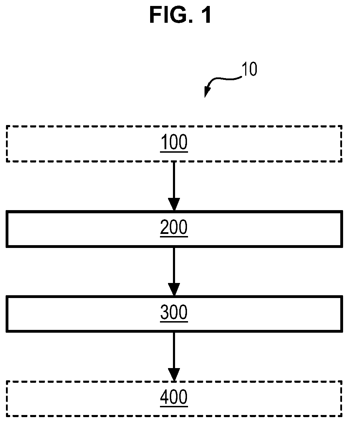

On a représenté sur la **Figure 1** un procédé 10 d'assemblage d'une pièce en silicium sur un support, dans le cadre de la fabrication d'un dispositif MEMS.

La pièce en silicium à assembler est typiquement, mais de manière non limitative, un actionneur MEMS ou un capteur MEMS.

Le support de la pièce n'est préférentiellement pas réalisé en silicium. On considère ici que le support est formé dans un matériau moins fragile que le silicium, ce qui permet de solliciter mécaniquement au moins une partie du support sans rupture du support.

Par exemple, le support est formé au moins pour partie en matériau métallique (de préférence de l'acier inoxydable et/ou du laiton et/ou du cuprobéryllium dit CuBe) et/ou est formé au moins pour partie en matériau céramique et/ou est formé au moins pour partie en matériau thermoplastique. De tels matériaux présentent généralement l'avantage d'être moins onéreux et plus facilement disponibles que le silicium.

La pièce en silicium peut être en contact avec le support sur toute la surface d'une face de la pièce, comme par exemple dans le cas d'une pièce positionnée sur une platine. Alternativement, la pièce en silicium est en contact avec le support sur seulement une partie d'une face de la pièce, voire seulement sur un bord de la pièce.

Au cours du procédé 10 d'assemblage, un outil vient solliciter mécaniquement la portion déformable du support, de sorte à déformer plastiquement ladite portion déformable. La portion déformable atteint alors une position déformée qui correspond de préférence à une position prédéterminée, permettant de réaliser une butée contre laquelle la pièce en silicium est maintenue en position. Par exemple, la butée empêche un mouvement de translation de la pièce en silicium dans au moins un sens le long d'une direction de l'espace et/ou empêche un mouvement de rotation de la pièce en silicium dans au moins un sens autour d'un axe de l'espace.

Comme il sera vu ci-après, l'outil comprend par exemple un poinçon de dureté supérieure à celle de la portion déformable et/ou comprend une tête vibrante prévue pour générer des frottements sur la portion déformable. La tête vibrante peut être une tête à ultrasons.

Le procédé 10 d'assemblage comprend, à une étape 100 optionnelle, un préchauffage de l'outil afin de permettre ensuite à l'outil de venir chauffer la portion déformable. De préférence, le préchauffage de l'outil est alors réalisé de sorte que l'outil atteigne une température supérieure ou égale à 80 degrés et inférieure ou égale à 200 degrés.

On notera que la température à laquelle l'outil est préchauffé est préférentiellement sélectionnée en fonction des propriétés du matériau de la portion déformable qui sera ensuite déformée à l'aide de l'outil. La portion déformable ne doit pas entièrement fondre.

L'outil, éventuellement chauffé au préalable, est ensuite mis au contact de la portion déformable du support au cours d'une étape 200. Par exemple, une tête de l'outil est déplacée de sorte à venir au contact de la portion déformable.

A une étape 300, une fois l'outil au contact de la portion déformable, l'outil sollicite mécaniquement cette portion de sorte à déformer plastiquement cette portion. Pendant cette étape de déformation 300, dans le cas où l'outil comprend une portion vibrante telle qu'une tête vibrante, ladite portion vibrante peut être activée de manière à générer des frottements entre l'outil et la portion déformable. La portion déformable est ainsi chauffée. Un tel chauffage facilite la déformation de la portion déformable.

La déformation plastique de la portion déformable par l'outil à l'étape 300 est, de manière préférentielle, une déformation contrôlée en termes de force mécanique exercée sur la portion déformable.

De manière préférentielle, la force mécanique exercée par l'outil sur la portion déformable au cours de la déformation plastique est supérieure ou égale à 5 Newton et inférieure ou égale à 20 Newton. Cette force peut être sélectionnée en fonction du matériau constitutif de la portion déformable et/ou en fonction de la forme de ladite portion.

Une fois déformée, la portion déformable s'étend contre la pièce en silicium - par exemple contre une surface périphérique de la pièce en silicium, ou contre un bord de la pièce en silicium - de sorte à former une butée qui participe à maintenir la pièce en silicium en position sur le support.

A une étape 400 optionnelle, les étapes 200 et 300 sont répétées autant de fois que nécessaire, le cas échéant au niveau de plusieurs portions déformables différentes de la pièce en silicium tels que des pions de positionnement différents, afin de finaliser l'assemblage de la pièce en silicium sur le support.

Des exemples particuliers d'un tel procédé d'assemblage sont exposés ci-après.

### Exemple 1 - Assemblage d'un actionneur en silicium sur une platine

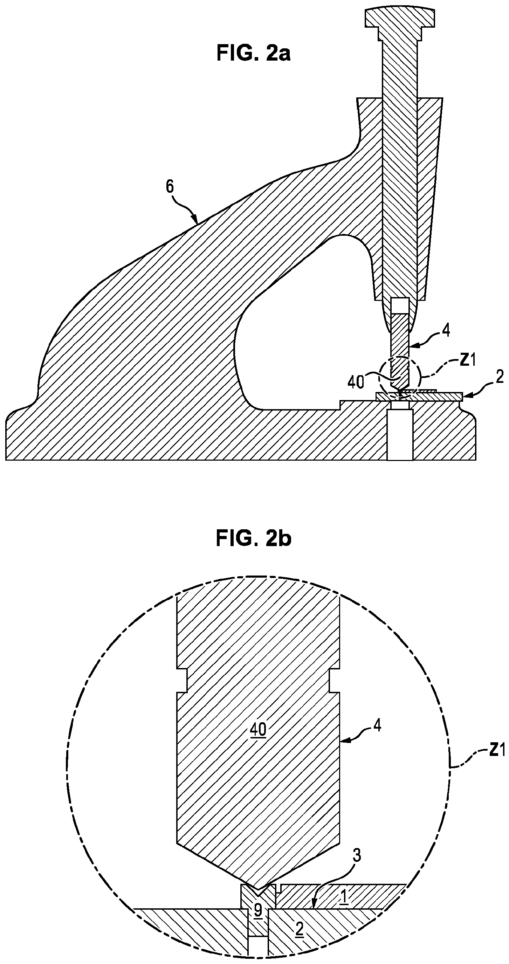

Les **Figures 2a et 2b** illustre schématiquement un premier exemple de réalisation dans lequel un actionneur 1 en silicium est assemblé sur une platine 2. La portion déformable de la platine 2 prévue pour buter contre l'actionneur 1 comprend au moins un élément de positionnement. Dans le présent exemple, l'élément de positionnement est un pion 9. Dans les schémas des Figures 2a et 2b, le pion 9 n'a pas encore été déformé.

Dans cet exemple, le pion 9 n'est pas d'une seule pièce avec la platine 2. Le pion 9 est rapporté sur la platine 2 préalablement à l'assemblage. Le pion 9 est par exemple inséré dans un canal 18 pratiqué à l'intérieur de la platine 2.

Le pion 9 est par exemple un pion à sertir, de préférence de forme générale cylindrique ou parallélépipédique. Le pion 9 peut être formé en matériau métallique tel que l'acier inoxydable et/ou le laiton et/ou le cuprobéryllium.

Le canal 18 prévu pour le positionnement d'un pion 9 est de préférence pratiqué dans la platine 2 lors de la fabrication de la platine 2. De préférence, une pluralité de canaux 18 sont présents dans la platine 2 et définissent des emplacements prédéterminés.

Dans cet exemple, l'actionneur 1 en silicium est une pièce de forme générale parallélépipédique. La platine 2 est ici également de forme générale parallélépipédique. L'actionneur 1 est superposé sur la platine 2. L'actionneur 1 comprend notamment une face supérieure à l'air libre, et une face inférieure réalisant une surface de contact 3 avec le support 2.

Une épaisseur moyenne E de l'actionneur 1 selon une direction perpendiculaire à la surface de contact 3 (ici selon une direction verticale) est, de préférence, supérieure ou égale à 10 micromètres et inférieure ou égale à 1,0 millimètre.

L'actionneur 1 en silicium est considéré comme une pièce plus fragile que la platine 2. Il est souhaitable de ne pas assembler l'actionneur 1 par chassage ou rivetage sur la platine 2 afin de ne pas menacer l'intégrité mécanique et fonctionnelle de l'actionneur 1.

L'assemblage est réalisé par un outil 4 positionné sur une potence 6, typiquement sur une potence horlogère. Au début du procédé d'assemblage, préalablement à l'étape 100 ou 200, l'actionneur 1 repose sur le support 2 via la surface de contact 3 et le support 2 repose lui-même sur un plateau inférieur de la potence 6. En alternative, une enclume pourrait être placée entre le support et le plateau inférieur. L'outil 4 est de préférence orienté perpendiculairement à la surface de contact 3 de l'actionneur et de la platine, c'est-à-dire verticalement ici.

Dans cet exemple, un pion 9 joue le rôle de portion déformable. Après déformation du pion 9 par l'outil 4, le pion 9 déformé est prévu pour venir en butée contre une surface périphérique 7 de l'actionneur 1. Selon l'orientation des Figures 2a à 6, la surface périphérique 7 correspond à un bord gauche de l'actionneur 1.

Préalablement à l'étape de déformation 300, le pion 9 est monté de manière fixe sur la platine 2, par exemple par insertion partielle dans le canal 18.

On a représenté sur la Figure 2b une vue rapprochée d'une zone Z1 du schéma de la Figure 2a, dans laquelle est visible le pion 9 monté fixement sur la platine 2. Du côté orienté vers la platine et vers l'actionneur, l'outil 4 se termine par une tête de poinçon 40 au contact du pion 9.

De manière très avantageuse, la portion déformable (ici le pion 9) comprend un trou 90 ménagé sur une surface supérieure de la portion déformable. L'outil 4 (plus particulièrement la tête de poinçon 40) peut alors présenter une forme complémentaire au trou 90. Ainsi, pendant l'étape 300 de déformation plastique de la portion déformable, l'outil 4 est inséré dans le trou 90 et pousse un bord de la portion déformable vers l'extérieur.

Comme indiqué ci-avant, de manière préférentielle, la force mécanique exercée par l'outil 4 sur le pion 9 au cours de l'étape 300 de déformation plastique est supérieure ou égale à 5 Newton et est inférieure ou égale à 20 Newton. Le choix de cette force peut dépendre du matériau du pion 9.

L'action mécanique de la tête de poinçon 40 sur le pion 9 peut optionnellement être accompagnée d'un chauffage du pion 9 et/ou de vibrations générant des frottements.

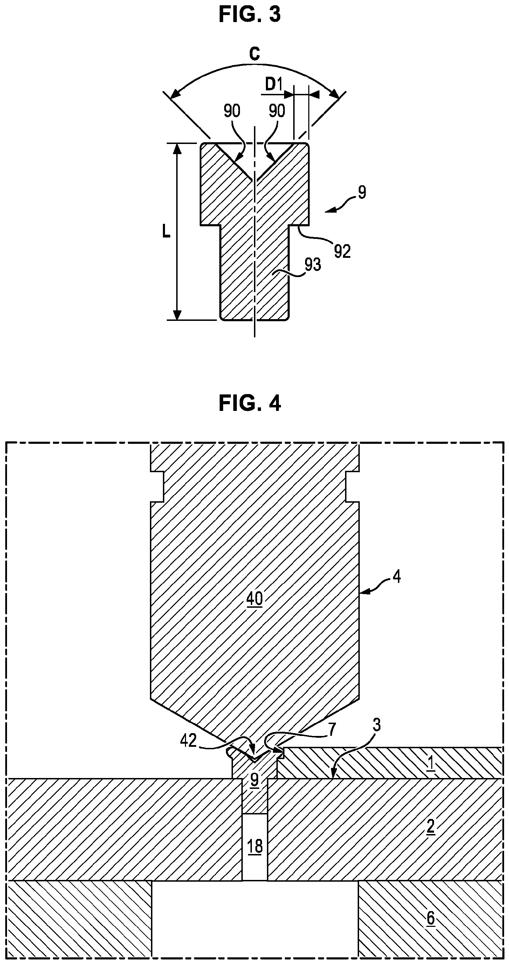

Selon une première variante illustrée sur la **Figure 3****,** le trou 90 présente une forme générale conique. Le trou 90 présente une ouverture angulaire C.

Un bord de pion d'épaisseur D1 est, de préférence, ménagé entre le trou 90 conique et le bord latéral extérieur du pion 9. Ainsi, lorsque la pointe 42 conique de la tête de poinçon 40 est insérée dans le trou 90, le bord de pion est déformé vers l'extérieur.

Un pion 9 selon cette première variante est illustré sur la **Figure 4** dans un état déformé vers l'extérieur.

De manière avantageuse, l'actionneur 1 peut présenter un coin évidé au niveau d'une arête supérieure de la surface périphérique 7, c'est-à-dire ici au niveau d'une arête supérieure du bord gauche de l'actionneur. Le coin est alors de préférence évidé en angle droit, comme visible sur la Figure 4. L'évidement du coin est de préférence réalisé tout le long de l'arête supérieure de l'actionneur 1.

Ainsi, une fois déformé par l'outil 4 à l'issue de la déformation 300, le bord du pion 9 s'engage à l'intérieur du coin évidé de l'actionneur 1 et forme une butée.

L'actionneur 1 est alors maintenu verticalement contre la platine 2 par le bord du pion 9 engagé dans le coin évidé, et est maintenu horizontalement par le pion 9. On peut répéter l'opération autant que nécessaire, éventuellement avec plusieurs éléments de positionnement tels que des pions supplémentaires, pour finaliser l'assemblage.

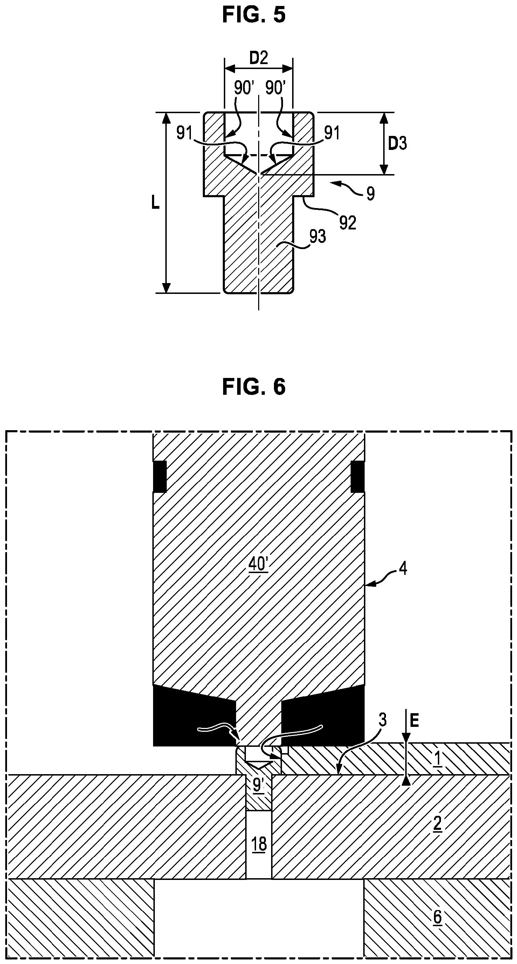

Selon une deuxième variante illustrée sur la **Figure 5****,** le trou 90' pratiqué dans la surface supérieure du pion 9 est de forme générale cylindrique. On a noté D2 le diamètre dudit trou 90' et on a noté D3 la longueur dudit trou 90'. De manière optionnelle, un trou supplémentaire conique 91 est pratiqué au fond du trou 90' cylindrique.

Un pion 9 selon la deuxième variante est illustré sur la **Figure 6** dans un état déformé vers l'extérieur. Ici, la tête de poinçon 40' de l'outil 4 se termine par un élément d'appui 42'. L'élément d'appui 42' se termine préférentiellement non pas en pointe, mais plutôt par une surface plane propre à appuyer contre la surface supérieure du pion 9 au cours de la déformation. L'élément d'appui 42' est par exemple de forme générale parallélépipédique.

Du fait de la présence du trou 90', le bord de pion du pion 9 des Figures 5 et 6 est apte à être déformé par flambage. Un appui de la tête de poinçon 40' sur le pion 9 fait flamber le bord de pion vers l'extérieur, comme cela est illustré sur la Figure 6. Ainsi, une fois déformé par l'outil 4 à l'issue de la déformation 300, le bord du pion 9 vient en appui contre la surface périphérique 7 de l'actionneur 1.

De manière commune aux deux variantes de pion (Figure 3 et Figure 5), le pion 9 présente de manière avantageuse une portion inférieure 93 de diamètre réduit, jointe à une portion supérieure du pion par un épaulement 92. La portion inférieure 93 de diamètre réduit s'étend de préférence sur au moins 25% d'une longueur L totale du pion 9, et s'étend plus préférentiellement entre 50% et 75% de la longueur L totale du pion 9.

D'une part, la portion inférieure 93 permet d'insérer le pion 9 dans le canal 18 de la platine 2, de sorte à positionner le pion 9 sur la platine 2 avant l'assemblage. D'autre part, une zone privilégiée de déformation est créée à l'intérieur du bord de pion, au-dessus de l'épaulement 92. La zone privilégiée de déformation peut être déformée par l'outil 4 pour faire pencher le bord de pion vers l'extérieur, et/ou faire flamber le bord de pion.

L'utilisation d'éléments de positionnement déformables rapportés sur le support, tels que des pions à sertir, est très avantageuse dans le cas où le support (ici la platine 2) est constitué pour tout ou partie d'un matériau difficilement déformable mécaniquement, tel que par exemple l'acier inoxydable ou tout autre métal de dureté élevée.

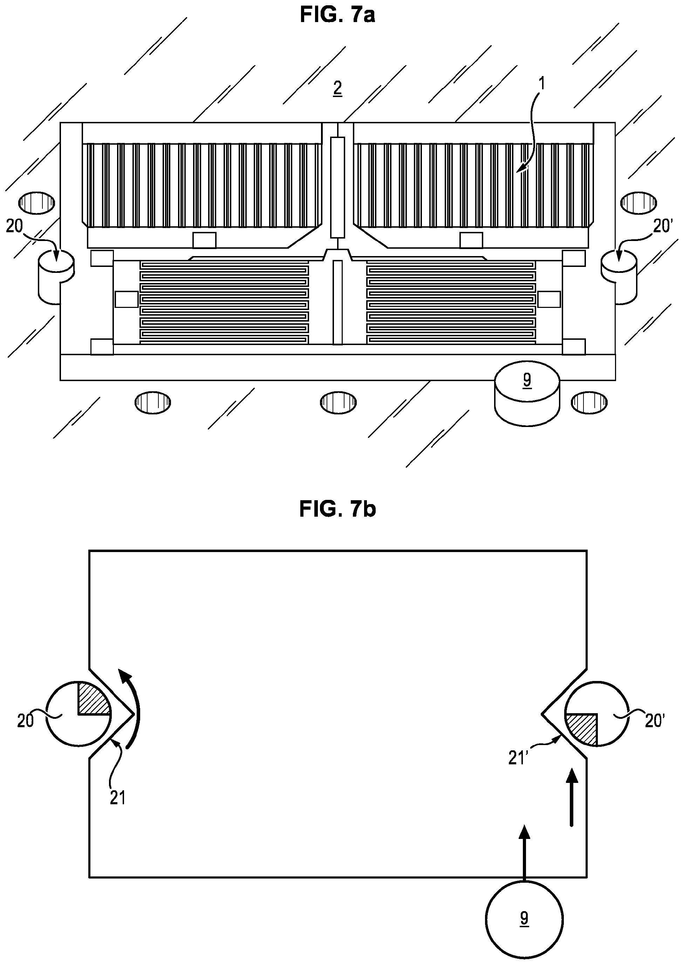

Un actionneur 1 en silicium, maintenu en place sur une platine 2 par l'intermédiaire d'un pion 9 et de deux éléments de repérage 20 et 20', est représenté à titre illustratif sur les **Figures 7a et 7b****.** L'actionneur 1 est un actionneur électromécanique. A titre d'exemple, l'actionneur 1 peut servir à induire un mouvement contrôlé de rotation d'une roue.

Le pion 9 constitue un élément de positionnement de l'actionneur 1 vis-à-vis de la platine 2. Les éléments de repérage 20 et 20', aussi appelés éléments de « locating », présentent par exemple une forme de goupilles.

Ici, préalablement à la déformation 300, l'élément de repérage 20 est au voisinage du bord gauche de l'actionneur 1, l'élément de repérage 20' est au voisinage du bord droit de l'actionneur 1, et le pion 9 est au voisinage du bord inférieur de l'actionneur 1. Après déformation, le pion 9 vient en contact avec les bords correspondants et forme une butée.

Dans l'exemple des Figures 7a et 7b, l'actionneur 1 présente des coins évidés tout le long de chacune de ses arêtes supérieures, de manière similaire à la Figure 4.

De manière optionnelle et avantageuse, au moins un élément de positionnement ou un élément de repérage est placé en vis-à-vis d'une encoche pratiquée dans la surface périphérique correspondante de l'actionneur 1. L'encoche est par exemple formée par enlèvement de matière. Ledit élément de positionnement ou de repérage est alors au moins partiellement placé à l'intérieur de l'espace de l'encoche.

A titre d'exemple, une encoche en V peut être pratiquée dans l'actionneur. Dans ce cas, les deux surfaces opposées de l'encoche en V forment de préférence un angle droit.

Dans l'exemple des Figures 7a et 7b :
- Les éléments de repérage 20 et 20' sont placés en vis-à-vis d'encoches en V respectives 21 et 21' de l'actionneur 1 ;
- Le pion 9 n'est en revanche pas nécessairement placé en vis-à-vis d'une encoche.

Un avantage de positionner un élément de repérage face à une encoche en V est de former deux surfaces de contact entre l'encoche en V et l'élément de repérage, lesdites deux surfaces présentant des directions normales différentes.

Ainsi, on obtient trois appuis sur l'actionneur 1 permettant de maintenir fermement l'actionneur 1 en position sur sa platine. Les trois appuis sont procurés respectivement par l'élément de repérage 20, l'élément de repérage 20' et le pion 9. Après assemblage de l'actionneur 1 sur la platine 2, l'actionneur 1 est donc empêché de se déplacer par rapport à la platine 2 selon toute direction dans le plan de la platine 2.

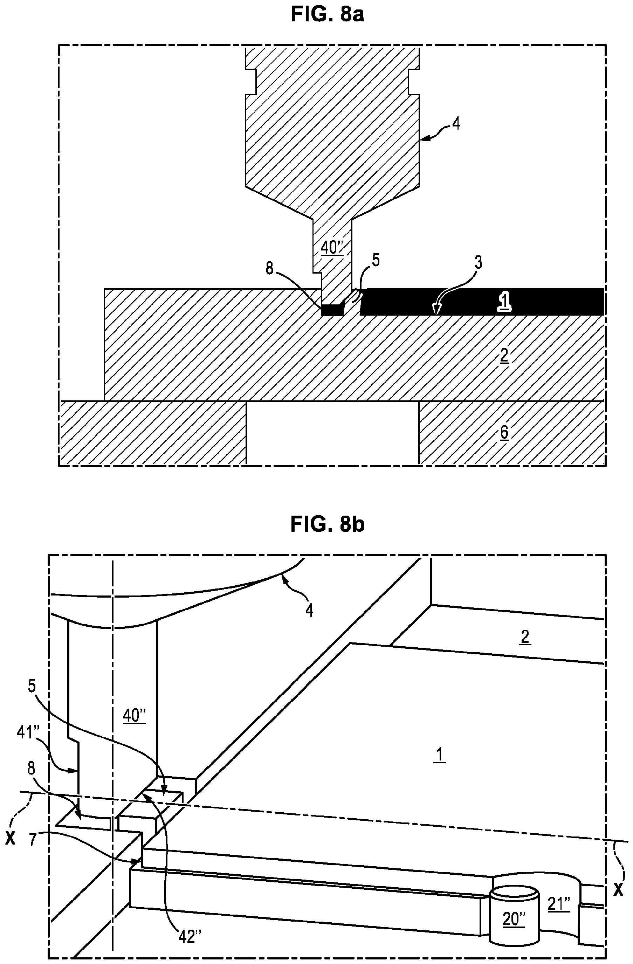

La **Figure 8a** est une vue en coupe d'une pièce en silicium en cours d'assemblage sur une platine, selon un deuxième exemple de réalisation dans lequel la portion déformable comprend une forme usinée directement dans le support. La portion déformable est préférentiellement formée en une seule pièce unique de matériau avec le reste de la platine.

De même que dans les exemples précédents, la pièce en silicium à assembler est ici par exemple un actionneur 1 reposant sur la platine 2 au niveau d'une surface de contact 3 correspondant à une face inférieure de l'actionneur. La platine 2 repose elle-même sur un plateau inférieur de la potence 6, qui est typiquement une potence horlogère.

La portion déformable du support comprend ici une portion flexible 5. La portion flexible 5 est d'une seule pièce avec la platine 2. La portion flexible 5 se situe face à la pièce en silicium à assembler, de préférence face à une surface périphérique de ladite pièce.

De manière avantageuse, la portion flexible 5 est située au voisinage immédiat de la surface de contact 3 et s'étend perpendiculairement à un plan de la surface de contact 3. La hauteur moyenne de la portion flexible 5 est de préférence égale ou légèrement supérieure à l'épaisseur moyenne de l'actionneur 1 selon une direction perpendiculaire à la surface de contact 3. La hauteur moyenne de la portion flexible 5 est par exemple supérieure ou égale à 100 micromètres et inférieure ou égale à 900 micromètres.

Ainsi, à partir d'une position droite de la portion flexible 5, ladite portion flexible peut être déformée pour pencher en direction de l'actionneur 1 comme illustré sur la Figure 8a, de sorte à former une butée contre l'actionneur 1. De préférence, comme précédemment, l'actionneur 1 comprend un coin évidé en vis-à-vis de la portion flexible 5. Après déformation, la portion flexible 5 s'étend alors en partie dans ledit coin évidé.

La portion flexible 5 a ici été obtenue en réalisant un évidement 8 dans la platine 2.

On a représenté sur la **Figure 8b** l'outil 4, l'actionneur 1 et la platine 2 vus du dessus. On a également représenté sur la Figure 8b le plan de coupe transversale X-X correspondant à la Figure 8a, la coupe passant par l'évidement 8, la portion flexible 5 et l'actionneur 1.

Comme représenté sur la Figure 8b, l'évidement 8 peut avoir une forme de U autour de la portion flexible 5, de sorte qu'une surface supérieure de la portion flexible 5 présente une forme générale rectangulaire.

Afin de réaliser la déformation plastique de la portion flexible 5, l'outil 4 comprend ici une tête d'outil 40" configurée pour pénétrer en partie dans l'évidement 8 et pour exercer une sollicitation mécanique sur la portion flexible 5 de sorte à la faire pencher en direction de l'actionneur 1.

Ici, la tête d'outil 40" comprend de préférence une surface de guidage 41" au niveau de sa pointe. La surface de guidage 41" est prévue pour appuyer contre une surface de fond de l'évidement 8 du côté opposé à l'actionneur 1. Ainsi, lors de la descente de la tête d'outil 40" vers la platine 2, la surface de guidage 41" guide de mouvement de la tête d'outil 40".

De manière préférentielle, la tête d'outil 40" comprend en outre un coin chanfreiné 42" opposé à la surface de guidage 41", également au niveau de la pointe. Le coin chanfreiné 42" est prévu pour appuyer sur la partie flexible 5, par exemple sur un côté de la partie flexible 5 opposé à l'actionneur 1.

La surface de guidage 41" et/ou le coin chanfreiné 42" sont de préférence obtenus par enlèvement de matière sur une tête d'outil 40" de forme initialement cylindrique.

Un assemblage de l'actionneur 1 sur la platine 2 peut comporter les étapes suivantes :
De manière optionnelle, à l'étape 100, la tête d'outil 40" peut être portée à haute température, par exemple supérieure ou égale à 80 degrés et inférieure ou égale à 200 degrés, notamment dans le cas où un matériau de la portion flexible 5 est un matériau thermoplastique déformable à haute température (par exemple polymère à cristaux liquides dit LCP, et/ou polyacide méthacrylique dit PMA).

A l'étape 200, l'outil 4 et notamment la tête d'outil 40" sont amenés au contact de la partie flexible 5 de la platine 2. Pour ce faire, la tête d'outil 40" est approchée de la partie flexible 5 selon une direction d'approche sensiblement verticale, jusqu'à ce que la surface de guidage 41" soit au contact de la platine 2 au niveau de l'évidement.

Ensuite, à l'étape 300, on continue d'approcher la tête d'outil 40" de la partie flexible 5 verticalement, et la paroi chanfreinée 42" vient appuyer sur un côté de la partie flexible 5. La partie flexible 5 subit ainsi une déformation plastique imposée par la tête d'outil 40". La force exercée sur ladite partie flexible est de préférence contrôlée, et est de préférence supérieure ou égale à 5 Newton et inférieure ou égale à 20 Newton.

De façon optionnelle, la tête d'outil 40" peut exercer en outre des vibrations sur la portion flexible 5 de sorte à faciliter la déformation, par exemple dans le cas d'un outil comportant une tête vibrante telle qu'une tête à ultrasons.

On répète enfin l'opération autant de fois que nécessaire, le cas échéant pour plusieurs portions flexibles, afin d'assembler l'actionneur 1 et d'assurer son maintien en position sur le support. Un avantage de cet exemple est que la portion flexible est d'une seule pièce avec le support ; il n'est pas nécessaire d'ajouter au processus d'assemblage une étape supplémentaire de positionnement d'un élément séparé, tel qu'un pion.

### Exemple 2 - Assemblage d'une roue en silicium sur un moyeu rotatif

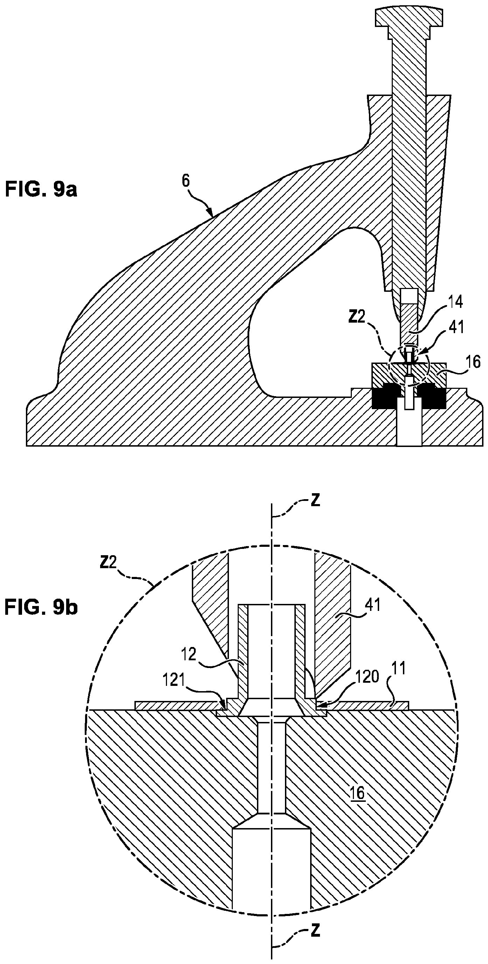

La **Figure 9a** illustre schématiquement une roue 11 en silicium en cours d'assemblage sur un moyeu 12, selon un troisième exemple de réalisation du procédé d'assemblage décrit précédemment. Une partie du moyeu 12 comprend une portion déformable prévue pour subir une sollicitation mécanique exercée par l'outil 14.

La roue 11 en silicium présente une forme générale de disque. L'épaisseur moyenne de la roue 11 perpendiculairement au plan d'extension de la roue 11 est très inférieure au diamètre de la roue 11. L'épaisseur de la roue 11 est par exemple supérieure ou égale à 10 micromètres et est inférieure ou égale à 1,0 millimètre.

A titre d'exemple, la roue 11 en silicium est une roue d'entraînement d'un dispositif MEMS. Il s'agit par exemple d'une roue d'entraînement configurée pour engrener avec un élément actif d'un actionneur MEMS, par exemple avec l'actionneur 1 précédemment décrit.

Le moyeu 12 présente avantageusement une forme générale cylindrique avec un évasement sur une portion inférieure. Le moyeu 12 est creux, de sorte qu'un arbre peut être monté à l'intérieur du moyeu 12 de manière concentrique avec le moyeu 12.

On notera que de manière alternative qui ne fait pas partie de la présente invention, la roue 11 pourrait être assemblée sur un arbre plein plutôt que sur un moyeu, selon un procédé similaire au procédé décrit ci-après.

Un matériau majoritaire de la roue 11 est le silicium. La roue 11 est donc fragile. Des microfissurations ou micro-ruptures pourraient être formées dans la roue 11 si cette roue 11 était assemblée sur le moyeu 12 par chassage ou rivetage. Le moyeu 12, quant à lui, est formé dans un matériau moins fragile que le silicium, de sorte qu'une portion déformable du moyeu 12 peut être sollicitée mécaniquement (et éventuellement chauffée et/ou frottée) sans rupture de la portion déformable.

Dans cet exemple, l'assemblage est réalisé par un outil 14 positionné sur une potence 6, typiquement sur une potence horlogère. Au début du procédé d'assemblage, dans le présent exemple, la roue 11 repose d'une part sur un bord extérieur 120 du moyeu 12, et d'autre part sur une surface supérieure d'une enclume 16. L'enclume 16 est positionnée entre le moyeu 12 et un plateau inférieur de la potence 6. En alternative, la roue 11 et le moyeu 12 pourraient reposer directement sur le plateau inférieur de la potence 6.

Au début de l'assemblage, la roue 11 et le moyeu 12 sont montés de manière concentrique et s'étendent autour d'un même axe longitudinal Z, le moyeu 12 s'étendant le long de l'axe Z. Au début de l'assemblage, l'outil 14 est de préférence orienté perpendiculairement au plan d'extension de la roue 11. Ainsi, selon l'orientation des Figures 9a et 9b, l'outil 14 s'étend verticalement.

On a représenté sur la Figure 9b une vue rapprochée d'une zone Z2 du schéma de la Figure 9a, dans laquelle est visible la roue 11 reposant en partie sur le moyeu 12 et reposant par ailleurs sur l'enclume 16.

Ici, la roue 11 est percée et définit en son centre une ouverture traversante 111 définie à l'intérieur d'un bord intérieur 110 de la roue 11. De préférence, l'ouverture traversante 111 est de forme circulaire. L'ouverture traversante 111 permet l'entraînement en rotation de la roue 11 par l'intermédiaire du moyeu 12.

Le bord intérieur 110 de la roue 11 est prévu pour être mis au contact du moyeu 12. De manière avantageuse, une micro-structuration du bord intérieur 110 a été réalisée préalablement à l'assemblage, par exemple pour former des micro-indentations ou micro-créneaux. On rappelle que le matériau silicium est particulièrement adapté pour obtenir des motifs géométriques micrométriques précis par gravure. La micro-structuration du bord intérieur 110 peut contribuer à la bonne tenue mécanique de la roue 11 sur le moyeu 12.

Préalablement à l'assemblage, le moyeu 12 est placé à l'intérieur de l'ouverture 111. De manière avantageuse, le moyeu 12 présente un coin à angle droit sur une portion inférieure du moyeu, et la roue 11 est positionnée sur le coin à angle droit. Le coin à angle droit joint d'une part un bord extérieur 120 du moyeu 12, de diamètre extérieur sensiblement identique au diamètre de l'ouverture traversante 111, et d'autre part une surface de positionnement 121 du moyeu 12 dont le diamètre extérieur est supérieur au diamètre de l'ouverture traversante 111.

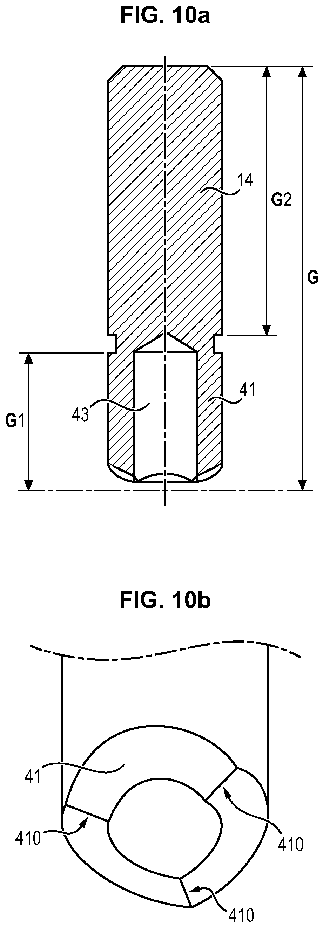

Comme visible sur les **Figures 10a et 10b****,** une extrémité libre de l'outil 14 de déformation se termine par une tête de poinçon 41 présentant un creux 43 sur une portion inférieure. Le creux 43 défini par la tête de poinçon 41 débouche vers l'extérieur de la tête de poinçon 41 et est dimensionné pour recevoir une portion supérieure du moyeu 12.

De préférence, les dimensions de l'outil 14 (et notamment de la tête de poinçon 41) sont sélectionnées en fonction des dimensions des composants à assembler.

Ainsi, dans le présent exemple, le creux 43 défini par la tête de poinçon 41 s'étend longitudinalement sur une portion longitudinale de l'outil 14 comprise entre 25% et 50% de la longueur totale G de l'outil 14. Par exemple, le creux 43 s'étend sur une longueur G1 comprise entre 2,0 millimètres et 8,0 millimètres, par exemple 5,0 millimètres, et la longueur G2 restante de l'outil 14 peut être comprise entre 4,0 millimètres et 16 millimètres, par exemple 10 millimètres.

Le diamètre du creux 43 est avantageusement supérieur ou égal à 1,0 millimètre et inférieur ou égal à 5,0 millimètres, et est par exemple égal à 2,0 millimètres ici.

La tête de poinçon 41 comprend, sur sa face intérieure et autour du creux 43, au moins une arête de déformation 410 apte à déformer la portion déformable du moyeu 12 lorsque ladite arête est pressée contre ladite portion déformable.

De préférence, la tête de poinçon 41 comprend une pluralité d'arêtes de déformation 410, avantageusement réparties régulièrement autour du creux 43. Dans le présent exemple, la tête de poinçon 41 comprend trois arêtes de déformation 410.

Les arêtes de déformation 410 sont par exemple obtenues en limant la portion inférieure de la tête de poinçon 41 selon un plan incliné.

La portion déformable du moyeu 12 prévue pour être déformée par la tête de poinçon 41 est, de manière préférée, une partie non fonctionnelle du moyeu 12. Ainsi, une déformation de cette portion déformable pour assurer le maintien en rotation de la roue 11 n'affecte pas les performances mécaniques de l'ensemble rotatif de la roue et du moyeu. Ici, la portion déformable comprend le bord extérieur 120 du moyeu 12 ; lorsqu'une arête de déformation 410 appuie sur le bord extérieur 120, un bossage peut être localement formé. Le bossage formé fait alors saillie vers l'extérieur depuis le bord extérieur 120.

Selon l'invention, la roue 11 en silicium comprend au moins une encoche 130 le long du bord intérieur 110. L'encoche 130 est ici obtenue sous forme d'évidement semi-circulaire.

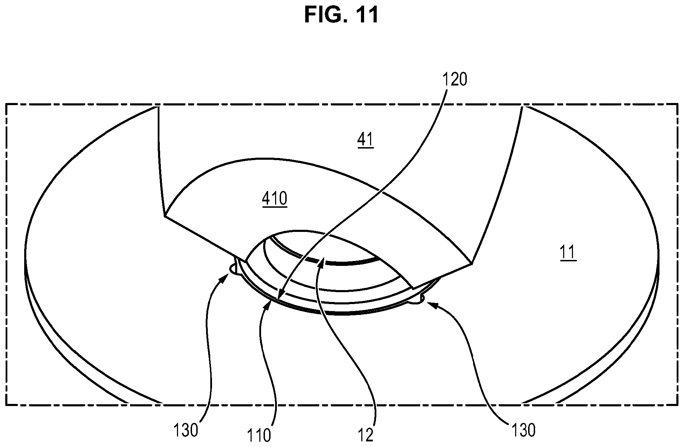

On dote avantageusement la roue 11 d'une pluralité d'encoches le long du bord intérieur 110, comme représenté sur la **Figure 11** annexée. Ici, la roue 11 en silicium comprend trois encoches 130 en correspondance avec les trois arêtes de déformation 410 de la tête de poinçon. La ou les encoches 130 sont de préférence prévues lors de la fabrication de la roue 11 en silicium. Ces encoches sont réalisées par exemple par micro-gravure.

Au cours de l'assemblage, pendant l'étape 300 de déformation plastique, une arête de déformation 410 appuie contre le bord extérieur 120 du moyeu 12 et sollicite mécaniquement ledit bord extérieur 120, de sorte qu'un bossage est formé au niveau dudit bord extérieur 120. Le bossage formé remplit tout ou partie de l'espace intérieur d'une encoche 130 de la roue 11.

La roue 11 en silicium est alors bloquée en rotation autour de l'axe Z par emboîtement du bossage faisant saillie du bord extérieur 120 du moyeu 12. On comprendra qu'une pluralité d'encoches 130 remplies par des bossages du moyeu 12 permettent de fiabiliser le blocage en rotation de la roue 11 autour de l'axe Z par rapport au moyeu 12.

De manière optionnelle, la tête de poinçon 41 peut être portée à haute température, par exemple à une température supérieure ou égale à 80 degrés et inférieure ou égale à 200 degrés, et/ou la tête de poinçon 41 peut être sollicitée pour générer des vibrations de sorte à faciliter la déformation du moyeu 12 et à former le bossage.

Un procédé d'assemblage de la roue 11 sur le moyeu 12 tel que décrit ci-avant comprenant une déformation locale du moyeu 12, pour éventuellement former des bossages au niveau d'encoches 130 de la roue 11, est avantageux car il s'agit d'une opération facile à intégrer au processus de fabrication d'un dispositif MEMS. De plus, un tel assemblage limite fortement les risques de dégradation mécanique de la roue 11.

## Revendications

1. Procédé d'assemblage d'une pièce (11) en silicium sur un moyeu (12), la pièce (11) en silicium comprenant une ouverture centrale (111) traversante, un bord intérieur (110) délimitant l'ouverture centrale (111) traversante et au moins une encoche (130) s'étendant à partir du bord intérieur (110), et le moyeu (12) comprenant une portion déformable, le procédé comprenant des étapes de :
placer le moyeu (12) à l'intérieur de l'ouverture centrale (111),
mettre en contact (200) un outil (14) avec la portion déformable ;
déformer plastiquement (300) la portion déformable par sollicitation mécanique de la portion déformable à l'aide de l'outil (14), de sorte qu'une fois déformée, la portion déformable s'étend contre la pièce (11) en formant une butée maintenant la pièce (11) en position sur le moyeu (12),
dans lequel l'étape de déformation plastique (300) a pour effet de déformer le moyeu (12) en formant un bossage pour remplir un espace de l'encoche (130), de manière à bloquer en rotation le moyeu (12) sur la pièce (11).

2. Procédé d'assemblage selon la revendication 1, le procédé comprenant une étape préliminaire de chauffage de l'outil (14) à une température supérieure ou égale à 80 degrés et inférieure ou égale à 200 degrés, de sorte à chauffer la portion déformable (15) au cours de l'étape de déformation (300).

3. Procédé d'assemblage selon l'une quelconque des revendications 1 ou 2, dans lequel l'outil (14) comprend un poinçon.

4. Procédé d'assemblage selon l'une des revendications 1 à 3, dans lequel l'outil comprend une tête vibrante, et dans lequel la tête vibrante est activée pendant l'étape de déformation plastique de manière à générer des frottements entre l'outil et la portion déformable, les frottements ayant pour effet de chauffer la portion déformable au cours de l'étape de déformation (300).

5. Procédé d'assemblage selon l'une quelconque des revendications 1 à 4, dans lequel le moyeu (12) comprend un matériau métallique, de préférence l'acier inoxydable et/ou le laiton et/ou le cuprobéryllium, et/ou comprend un matériau céramique.

6. Procédé d'assemblage selon l'une quelconque des revendications 1 à 4, dans lequel le moyeu (12) comprend un matériau thermoplastique, de préférence un polymère à cristaux liquides et/ou un polyacide méthacrylique.

7. Procédé d'assemblage selon l'une des revendications 1 à 6, dans lequel la portion déformable est formée en une seule pièce unique de matériau avec le reste du moyeu (12).

8. Procédé d'assemblage selon l'une quelconque des revendications 1 à 7, dans lequel la pièce (11) repose sur une enclume (16) au cours de l'étape de déformation (300).

9. Procédé d'assemblage selon l'une quelconque des revendications 1 à 8, dans lequel la pièce (11) comprend une surface de contact (13) et repose sur le moyeu (12) via la surface de contact (13), une épaisseur moyenne (E) de la pièce (11) selon une direction perpendiculaire à la surface de contact (13) étant supérieure ou égale à 10 micromètres et inférieure ou égale à 1,0 millimètre.

10. Dispositif MEMS comprenant un moyeu (12) et une pièce (11) en silicium assemblée fixement sur le moyeu (12), le dispositif MEMS ayant été obtenu par un procédé d'assemblage selon l'une quelconque des revendications 1 à 9.

11. Dispositif MEMS selon la revendication 10, dans lequel la pièce (11) en silicium comprend une roue d'entraînement.

## Patentansprüche

1. Verfahren zum Fügen eines Siliziumteils (11) an eine Nabe (12), wobei das Siliziumteil (11) eine durchgehende zentrale Öffnung (111), einen durchgehenden Innenrand (110), der die zentrale Öffnung (111) begrenzt, und wenigstens eine Kerbe (130) umfasst, die sich vom Innenrand (110) erstreckt, und die Nabe (12) einen verformbaren Abschnitt umfasst, wobei das Verfahren folgende Schritte umfasst:
die Nabe (12) in die zentrale Öffnung (111) einsetzen,
ein Werkzeug (14) mit dem verformbaren Abschnitt in Kontakt bringen (200);
den verformbaren Abschnitt durch mechanische Beanspruchung des verformbaren Abschnitts mit dem Werkzeug (14) plastisch (300) verformen, sodass sich der verformbare Abschnitt nach dem Verformen gegen das Teil (11) erstreckt, indem er einen Anschlag bildet, der das Teil (11) in Position an der Nabe (12) hält, wobei der plastische Verformungsschritt (300) bewirkt, dass er die Nabe (12) verformt, indem er eine Erhebung bildet, um einen Raum der Kerbe (130) zu füllen, sodass die Nabe (12) am Teil (11) gegen Verdrehen gesichert wird.

2. Fügeverfahren nach Anspruch 1, wobei das Verfahren einen Vorerwärmungsschritt des Werkzeugs (14) auf eine Temperatur größer oder gleich 80 Grad und kleiner oder gleich 200 Grad umfasst, so dass der verformbare Abschnitt (15) während des Verformungsschritts (300) erwärmt wird.

3. Fügeverfahren nach einem der Ansprüche 1 oder 2, wobei das Werkzeug (14) einen Stempel umfasst.

4. Fügeverfahren nach einem der Ansprüche 1 bis 3, wobei das Werkzeug einen Vibrationskopf umfasst und wobei der Vibrationskopf während des plastischen Verformungsschritts aktiviert wird, um Reibung zwischen dem Werkzeug und dem verformbaren Abschnitt zu erzeugen, wobei die Reibung die Erwärmung des verformbaren Abschnitts während des Verformungsschritts bewirkt (300).

5. Fügeverfahren nach einem der Ansprüche 1 bis 4, wobei die Nabe (12) einen metallischen Werkstoff, vorzugsweise Edelstahl und/oder Messing und/oder Berylliumkupfer, und/oder einen Keramikwerkstoff umfasst.

6. Fügeverfahren nach einem der Ansprüche 1 bis 4, wobei die Nabe (12) einen thermoplastischer Werkstoff, vorzugsweise ein Flüssigkristallpolymer und/oder eine Polymethacrylsäure, umfasst.

7. Fügeverfahren nach einem der Ansprüche 1 bis 6, wobei der verformbare Teil zusammen mit dem Rest der Nabe (12) aus einem einzigen Werkstoffstück gebildet wird.

8. Fügeverfahren nach einem der Ansprüche 1 bis 7, wobei das Teil (11) während des Verformungsschritts (300) auf einem Amboss (16) aufliegt.

9. Fügeverfahren nach einem der Ansprüche 1 bis 8, wobei das Teil (11) eine Kontaktfläche (13) umfasst und über die Kontaktfläche (13) auf der Nabe (12) aufliegt, wobei eine durchschnittliche Dicke (E) des Teils (11) in einer Richtung senkrecht zur Kontaktfläche (13) größer oder gleich 10 Mikrometer und kleiner oder gleich 1,0 Millimeter ist.

10. MEMS-Vorrichtung, die eine Nabe (12) und ein an die Nabe (12) fest angefügtes Siliziumteil (11) umfasst, wobei die MEMS-Vorrichtung durch ein Fügeverfahren nach einem der Ansprüche 1 bis 9 hergestellt wurde.

11. MEMS-Vorrichtung nach Anspruch 10, wobei das Siliziumteil (11) ein Antriebsrad umfasst.

## Claims

1. A method for assembling a silicon part (11) to a hub (12), the silicon part (11) comprising a central through opening (111), an internal edge (110) delimiting the central through opening (111) and at least one notch (130) extending from the internal edge (110), and the hub (12) comprising a deformable portion, the method comprising steps of:
placing the hub (12) inside the central opening (111),
bringing a tool (14) into contact (200) with the deformable portion;
plastically deforming (300) the deformable portion by mechanically biasing the deformable portion using the tool (14), such that once deformed, the deformable portion extends against the part (11) by forming a stop holding the part (11) in position on the hub (12), wherein the plastic deformation step (300) has the effect of deforming the hub (12) by forming a boss to fill a space of the notch (130), so as to rotatably block the hub (12) on the part (11).

2. The assembly method according to claim 1, the method comprising a preliminary step of heating the tool (14) to a temperature greater than or equal to 80 degrees and less than or equal to 200 degrees, so as to heat the deformable portion (15) during the deformation step (300).

3. The assembly method according to any of claims 1 or 2, wherein the tool (14) comprises a punch.

4. The assembly method according to any of claims 1 to 3, wherein the tool comprises a vibrating head, and wherein the vibrating head is activated during the plastic deformation step so as to generate friction between the tool and the deformable portion, the friction having the effect of heating the deformable portion during the deformation step (300).

5. The assembly method according to any of claims 1 to 4, wherein the hub (12) comprises a metal material, preferably stainless steel and/or brass and/or beryllium copper, and/or comprises a ceramic material.

6. The assembly method according to any of claims 1 to 4, wherein the hub (12) comprises a thermoplastic material, preferably a liquid crystal polymer and/or a polymethacrylic acid.

7. The assembly method according to one of claims 1 to 6, wherein the deformable portion is formed as a single piece of material with the rest of the hub (12) .

8. The assembly method according to any of claims 1 to 7, wherein the part (11) rests on an anvil (16) during the deformation step (300).

9. The assembly method according to any of claims 1 to 8, wherein the part (11) comprises a contact surface (13) and rests on the hub (12) via the contact surface (13), an average thickness (E) of the part (11) along a direction perpendicular to the contact surface (13) being greater than or equal to 10 micrometres and less than or equal to 1.0 millimetre.

10. A MEMS device comprising a hub (12) and a silicon part (11) fixedly assembled to the hub (12), the MEMS device having been obtained by an assembly method according to any of claims 1 to 9.

11. The MEMS device according to claim 10, wherein the silicon part (11) comprises a drive wheel.
